Europäisches Patentamt

European Patent Office

Office européen des brevets

(19)

(11) Veröffentlichungsnummer : **0 199 250 B1**

(12) **EUROPÄISCHE PATENTSCHRIFT**

(45) Veröffentlichungstag der Patentschrift :
24.01.90

(51) Int. Cl.⁵ : **H 03 K 17/95**

(21) Anmeldenummer : 86105128.2

(22) Anmeldetag : 14.04.86

(54) Induktiver Annäherungsschalter.

(30) Priorität : 24.04.85 DE 3514833

(43) Veröffentlichungstag der Anmeldung :
29.10.86 Patentblatt 86/44

(45) Bekanntmachung des Hinweises auf die Patenterteilung : 24.01.90 Patentblatt 90/04

(84) Benannte Vertragsstaaten :
DE FR GB IT

(56) Entgegenhaltungen :
DE--A-- 1 966 178
DE--A-- 2 113 556
FR--A-- 2 110 146

(73) Patentinhaber : Siemens Aktiengesellschaft
Wittelsbacherplatz 2
D-8000 München 2 (DE)

(72) Erfinder : Wiesgickl, Bernhard, Dipl.-Ing.(FH)
Nr. 258
D-8453 Vilseck (DE)

## Beschreibung

Die Erfindung bezieht sich auf einen induktiven Annäherungsschalter mit einem einen von außen bedämpfbaren Schwingkreis enthaltenden Oszillator und einem vom Oszillator steuerbaren elektronischen Schalter, von dessen Schaltsignal eine Schalthysterese abgeleitet ist.

Bei einem bekannten Annäherungsschalter der obengenannten Art (DE-A-19 66 178) ist zur Bildung einer Schalthysterese die Reihenschaltung aus einem Hilfswiderstand, einer Diode und der Kollektor-Emitter-Strecke eines Steuertransistors dem Emitter-Widerstand des Oszillator-Transistors parallel geschaltet. Hierdurch ist zwar auch eine vom Schaltzustand des Annäherungsschalters abhängige Hysterese erreichbar ; die Verstellung der Hysterese verstellt jedoch automatisch auch die Empfindlichkeit des Annäherungsschalters.

Aus DE-A-2 113 556 ist ein Annäherungsschalter bekannt, bei dem die Arbeitsfrequenz des Oszillators zur Kompensation von Umgebungseinflüssen über eine Verzögerungsschaltung automatisch nachgestimmt wird.

Durch die vorliegende Erfindung soll ein induktiver Annäherungsschalter geschaffen werden, der — wie beim Stand der Technik — über einen relativ großen Bereich mit einer Schalthysterese eingestellt werden kann, bei dem jedoch die Einstellung der Hysterese im wesentlichen ohne Einfluß auf die Empfindlichkeit des Oszillators bzw. des Beros (Berührungsloser Oszillator) ist. Diese Aufgabe wird bei einem Annäherungsschalter der obengenannten Art auf einfache Weise dadurch erreicht, daß eine Einrichtung zur Frequenzänderung bei bedämpftem Oszillator in Abhängigkeit vom Schaltsignal des elektronischen Schalters vorgesehen ist. Praktisch ohne Mehraufwand läßt sich die erfindungsgemäße Schaltungsanordnung realisieren, wenn bei Verwendung eines PLL-gesteuerten Oszillators, wie er beispielsweise aus der DE-OS-32 21 888 bekannt ist, eine Umschaltung des VCO vorgesehen ist. Die VCO-Frequenzänderung wird vorteilhafterweise durch Umschalten eines Widerstandes erreicht.

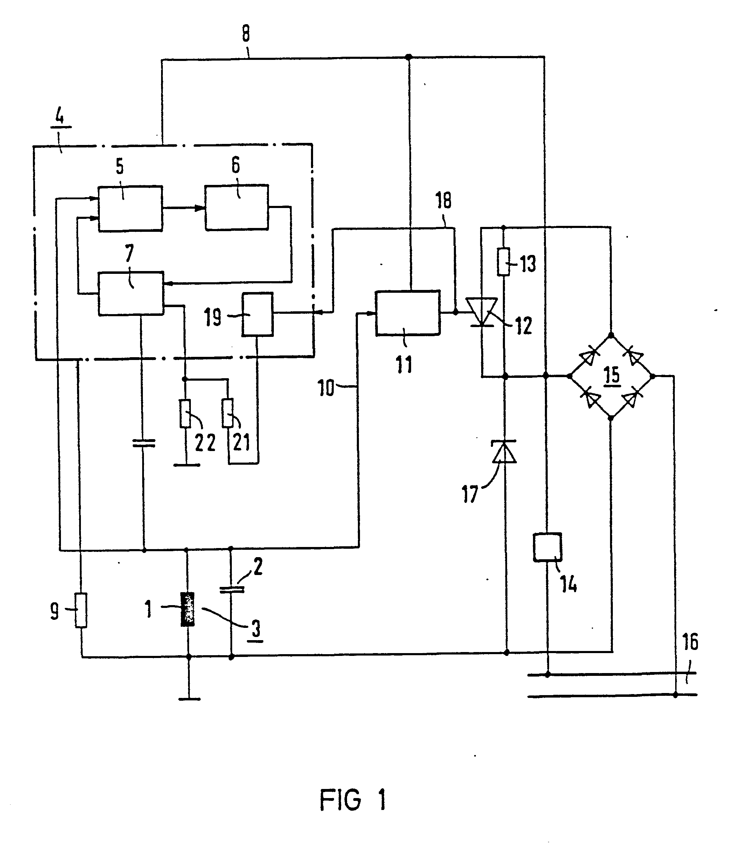

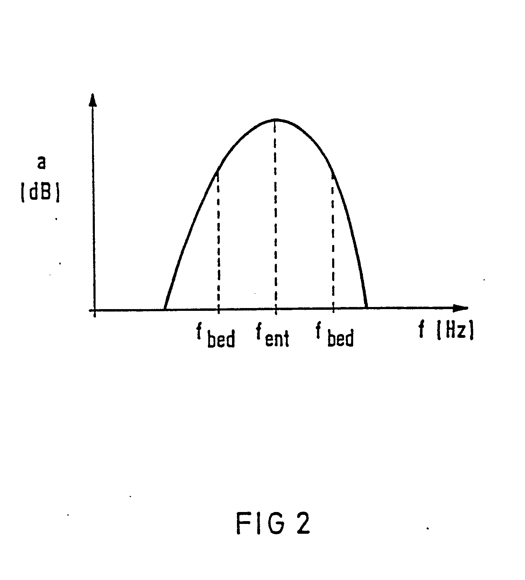

Anhand der Zeichnung wird in Fig. 1 eine mögliche Schaltungsanordnung für den erfindungsgemäßen induktiven Annäherungsschalter und in Fig. 2 die Übertragungsfunktion des für die Erfindung notwendigen Schwingkreises dargestellt.

Die in Fig. 1 prinzipmäßig dargestellte Schaltungsanordnung für den Annäherungsschalter besteht aus dem aus der Spule 1 und dem Kondensator 2 bestehenden Schwingkreis 3, an dem der Phasenregelkreis 4 (PLL = phase-locked Loop, wie er aus der Zeitschrift « Der Elektroniker », Nr. 6/1975, Seite EL 11, bekannt ist), angeschlossen ist. Der Phasenregelkreis besteht aus dem Phasen-Detektor 5, dem Schleifenfilter 6 und dem spannungsgesteuerten Oszillator (VCO = voltage controles oszillator) 7. Die Stromversorgung für den Phasenregelkreis 4 erfolgt über die Leitung 8 und den Widerstand 9. Die Leitung 10 wird an einen Amplitudendetektor 11 angeschlossen, der seinerseits einen elektronischen Schalter 12 ansteuert, vorzugsweise einen Thyristor. Der elektronische Schalter 12 schließt bei bedämpften Oszillator den Widerstand 13 kurz, so daß die Last 14 über die Gleichrichterbrücke 15 an das Netz 16 gelegt werden kann. Der Widerstand 13 ist Teil der aus Zenerdiode 17 und Widerstand 13 bestehenden Speiseschaltung zur Erzeugung der Versorgungsspannung für den phasenregelkreis 4 und den Amplitudendetektor 11.

Vom Steueranschluß 18 des elektronischen Schalters 12 wird über einen weiteren elektronischen Schalter 19 ein Widerstand 21 zu- oder abgeschaltet, wodurch sich die VCO-frequenz ändert, abhängig vom Schaltzustand des Annäherungsschalters. Die Frequenz $f_{ent}$ wird durch den Widerstand 22 eingestellt.

In Fig. 2 ist die Übertragungsfunktion des Schwingkreises 3 dargestellt. Bei entdämpftem Annäherungsschalter liegt die Oszillatorfrequenz bei $f_{ent}$. Durch die VCO-Frequenzumschaltung — wie oben dargestellt — wird dem Annäherungsschalter bei Bedämpfung eine andere Frequenz eingeprägt. Diese Frequenz ist mit $f_{bed}$ bezeichnet und kann wahlweise höher oder niedriger als $f_{ent}$ sein. Hierbei hat die Übertragungsfunktion des Schwingkreises eine höhere Dämpfung, so daß durch diese zusätzliche Dämpfung eine Hysterese entsteht. Die Wahl der Hysterese kann durch die Frequenz bestimmt werden. Durch Verwendung des Phasenregelkreises 4, der sowohl für die Erzeugung der entdämpften als auch der bedämpften Frequenz im Ausführungsbeispiel benutzt werden kann, werden diese Frequenzen relativ konstant gehalten. Der Einfluß der Temperaturdrift wird ebenfalls durch den Phasenregelkreis (PLL-Schaltung) mit dem steuerbaren Oszillator (VCO) korrigiert.

Die in Fig. 1 dargestellte Schaltung hat insbesondere den Vorteil, daß für die Schaffung der Hysterese praktisch kein gesonderter Aufwand notwendig ist, da die PLL-Schaltung im Annäherungsschalter ohnehin vorhanden ist. Die PLL-Schaltung kann in einem IC mit dem Amplitudendetektor und dem Schaltelement verwirklicht werden. Die Hysterese ist nach dem Schaltabstandsabgleich des Beros einstellbar. Wird z. B. der in Fig. 1 dargestellte Widerstand 11 als Potentiometer ausgeführt, os ist die Hysterese vom Anwender einstellbar.

## Patentansprüche

1. Induktiver Annäherungsschalter mit einem einen von außen bedämpfbaren Schwingkreis enthaltenden Oszillator und einem vom Oszillator steuerbaren elektronischen Schalter, von dessen Schaltsignal eine Schalthysterese abgeleitet ist, dadurch gekennzeichnet, daß eine Einrichtung zur Frequenzumschaltung (19) bei bedämpftem Oszillator (3, 7) in Abhängigkeit vom Zustand des Schaltsignals des elektronischen Schalters (12) vorgesehen ist.

2. Annäherungsschalter nach Anspruch 1, dadurch gekennzeichnet, daß bei Verwendung eines PLL (4) (Phase-locked-Loop)-gesteuerten Oszillators eine Umschaltung (19) des VCO (voltage controlled oszillator) (7) vorgesehen ist.

3. Annäherungsschalter nach Anspruch 1 oder 2, dadurch gekennzeichnet, daß die Frequenzumschaltung durch Umschalten eines Widerstandes (21, 22) erreicht ist.

## Claims

1. Inductive proximity switch with an oscillator comprising an oscillating circuit which may be externally damped and with an electronic switch which is controllable by the oscillator and from whose switching signal is derived a switching hysteresis, characterised in that there is provided a device for switching over the frequency (19) when the oscillator (3, 7) is damped depending on the status of the switching signal of the electronic switch (12).

2. Proximity switch according to claim 1, characterised in that when an oscillator controlled by a PLL (phase-locked-loop) (4) is used, a switch-over (19) of the VCO (voltage controlled oscillator) 7 is provided.

3. Proximity switch according to claim 1 or 2, characterised in that the frequency switch-over is achieved by switching over a resistance (21, 22).

## Revendications

1. Commutateur de proximité inductif, possédant un oscillateur qui contient un circuit oscillant pouvant être amorti de l'extérieur, ainsi qu'un interrupteur électronique commandé par l'oscillateur et fournissant un signal de commutation d'où est tirée une hystérésis de commutation, caractérisé en ce qu'il comprend un dispositif pour la commutation de fréquence (19), lorsque l'oscillateur (3, 7) est amorti, en fonction de l'état du signal de commutation de l'interrupteur électronique (12).

2. Commutateur selon la revendication 1, caractérisé en ce que, en cas d'utilisation d'un oscillateur commandé par une boucle à verrouillage de phase (4) ou PLL (« phase-locked-loop »), l'oscillateur commandé par tension (7) ou VCO (« voltage controlled oscillator ») est commuté par un dispositif de commutation (19).

3. Commutateur selon la revendication 1 ou 2, caractérisé en ce que la commutation de fréquence est obtenue par la commutation d'une résistance (21, 22).

FIG 1

FIG 2